# EUROPEAN PATENT APPLICATION

(11) **EP 4 782 854 A1**
(43) Date of publication of application: **29.07.2026**
(21) Application number: 25867230.2
(22) Date of filing: 28.11.2025
(51) Int. Cl.: G01R 31/392

(54) **BATTERY PACK COMPRISING MONOPOLE ANTENNA, AND BATTERY PACK INSPECTION DEVICE FOR INSPECTING SAME**

(30) Priority: 06.12.2024 KR 20240180208
(71) Applicant: LG ENERGY SOLUTION, LTD., Seoul 07335 (KR)
(72) Inventor: KANG, Dong Myung, Daejeon 34122 (KR)
(74) Representative: Plasseraud IP
(86) International application number: PCT/KR2025/020040
(87) International publication number: WO 2026/121720

(57) **Abstract**

Disclosed are a battery pack including a plurality of cylindrical battery cells, a metal plate configured to electrically connect the plurality of cylindrical battery cells to each other, a monopole antenna attached to the plurality of cylindrical battery cells, and an antenna module connected to the monopole antenna, and a battery pack inspection apparatus for inspecting the same.

## Description

### [Technical Field]

This application claims the benefit of priority to Korean Patent Application No. 2024-0180208 filed on December 6, 2024, the disclosure of which is incorporated herein by reference in its entirety.

The present invention relates to a battery pack including a monopole antenna and a battery pack inspection apparatus for inspecting the same. More particularly, the present invention relates to a battery pack including a monopole antenna capable of determining whether each battery cell in a battery pack including a plurality of battery cells is defective using a non-destructive inspection method and a battery pack inspection apparatus for inspecting the same.

### [Background Art]

A lithium secondary battery, which is capable of being charged and discharged, has been widely used as an energy source for wireless mobile devices or wearable devices, which are worn on bodies, and has also been used as an energy source for electric vehicles and hybrid electric vehicles presented as alternatives to existing gasoline and diesel vehicles, which cause air pollution.

Due to high energy density thereof, the lithium secondary battery may explode upon overheating, and once ignited, the lithium secondary battery is difficult to extinguish until the lithium secondary battery burns out.

Meanwhile, in order to meet the demand for high-voltage and high-power energy sources, a battery module or battery pack including a plurality of battery cells may be assembled for use, and it is necessary to determine whether any defective battery cells exist among the plurality of battery cells in the battery module or the battery pack in order to address risks such as the risk of explosion.

Conventionally, however, it is difficult to identify defective battery cells without disassembling the battery module or the battery pack, and it is difficult to determine whether an individual battery cell is defective using a method of measuring the voltage of the battery module or the battery pack.

Furthermore, a wired sensor may be attached to each battery cell in order to determine whether the battery cell is defective. In this case, however, additional costs are required to form a line for wired sensing.

Patent Document 1 discloses a battery management apparatus including a communication unit configured to transmit a first signal to a battery cell, a switch configured to connect the communication unit and the battery cell to each other, and a controller configured to control the operation of the switch, to receive a second signal corresponding to the first signal, and to diagnose the state of the battery cell based on the second signal.

In Patent Document 1, the state of the battery cell is diagnosed based on the second signal transmitted by the battery cell. The communication unit is wired to the battery cells, and the second signal indicating the state of the battery cells is transmitted via a wired line.

Therefore, equipment is required to construct the wired line, necessitating expenditure of costs for this purpose.

Patent Document 2 discloses a battery module including a plurality of battery cells constituting the battery module, RFID tags attached to the plurality of battery cells, and a printed circuit board provided with a radio frequency receiver configured to receive temperature signals transmitted by the RFID tags.

In Patent Document 2, the radio frequency receiver must be provided in plural in order receive the temperature signals transmitted by the plurality of battery cells.

Therefore, there is a need for technology capable of easily and quickly identify any defective battery cells among a plurality of battery cells constituting a battery pack and simplifying equipment therefor to prevent waste of space and cost.

### (Prior Art Documents)

(Patent Document 1) Korean Patent Application Publication No. 2024-0016134 (2024.02.06)
(Patent Document 2) Korean Patent Application Publication No. 2020-0022309 (2020.03.03)

### [Disclosure]

### [Technical Problem]

The present invention has been made in view of the above problems, and it is an object of the present invention to provide a battery pack including a monopole antenna capable of wirelessly checking changes in the state of cylindrical battery cells mounted in a battery pack to detect defective battery cells and a battery pack inspection apparatus for inspecting the same.

### [Technical Solution]

A battery pack according to the present invention to accomplish the above object includes a plurality of cylindrical battery cells, a metal plate configured to electrically connect the plurality of cylindrical battery cells to each other, a monopole antenna attached to the plurality of cylindrical battery cells, and an antenna module connected to the monopole antenna.

In the battery pack according to the present invention, the monopole antenna may be attached to each of the plurality of cylindrical battery cells.

In the battery pack according to the present invention, the monopole antenna may be coupled, by welding, to a metal plate coupled to a positive electrode terminal of the cylindrical battery cell.

In the battery pack according to the present invention, the monopole antenna may be made of a metal piece including copper or nickel.

In the battery pack according to the present invention, the monopole antenna may be rectangular in plan, and the length of a longer side of the rectangle may be less than the diameter of the cylindrical battery cell.

In the battery pack according to the present invention, the length of a short side of the rectangular the monopole antenna may be 1 mm or more.

A battery pack inspection apparatus for inspecting the battery pack according to the present invention includes a power supply device configured to supply power to the antenna module and a measurement device configured to measure the pattern of the monopole antenna attached to the battery pack.

In the battery pack inspection apparatus according to the present invention, the measurement device may be an electromagnetic anechoic chamber, and the battery pack may be disposed in the electromagnetic anechoic chamber, which may analyze a 3D pattern radiated by the monopole antenna.

In the battery pack inspection apparatus according to the present invention, the measurement device may be a spectrum analyzer, and the spectrum analyzer may be connected to the battery pack to analyze the pattern of a measured signal.

In the battery pack inspection apparatus according to the present invention, the monopole antenna may radiate different radiation patterns depending on impedance of a cylindrical battery cell to which the monopole antenna is coupled, and the measurement device may measure the radiation pattern of the monopole antenna, and, if any one of the radiation patterns radiated by a plurality of monopole antennas is different in shape from the others, may determine that the cylindrical battery cell corresponding to the different radiation pattern is defective.

In addition, the present invention may provide various combinations of the above solving means.

### [Advantageous Effects]

According to the present invention, monopole antennas are attached to all battery cells, and radiation patterns of the monopole antennas are analyzed to identify any defective battery cells. To this end, a non-destructive inspection method that does not require disassembly of a battery pack is used.

In addition, since a battery cell with a monopole antenna that transmits an abnormal pattern, among signals transmitted by the monopole antennas attached to the battery cells, can be determined to be defective, and therefore it is possible to easily and accurately determine whether a battery cell is defective.

Furthermore, since the radiation patterns of the monopole antennas can be analyzed wirelessly, the construction of a wired sensing line to detect signals transmitted by the battery cells is unnecessary, whereby it is possible to reduce the associated costs.

### [Description of Drawings]

FIG. 1 is a schematic view showing the interior of a battery pack according to the present invention.
FIG. 2 is an exploded perspective view showing the relationship in which a monopole antenna and a metal plate are coupled to a cylindrical battery cell of FIG. 1.
FIG. 3 is a view showing the configuration of a battery pack inspection apparatus according to the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

The same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

A description to embody elements through limitation or addition may be applied to all inventions, unless particularly restricted, and does not limit a specific invention.

In the description of the invention and the claims of the present application, singular forms are intended to include plural forms unless mentioned otherwise.

In the description of the invention and the claims of the present application, "or" includes "and" unless mentioned otherwise. Therefore, "including A or B" means three cases, namely, the case including A, the case including B, and the case including A and B.

Embodiments of the present invention will be described in more detail with reference to the drawings.

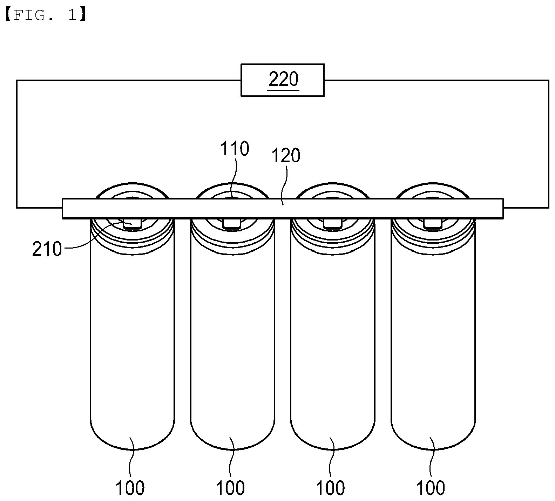

FIG. 1 is a schematic view showing the interior of a battery pack according to the present invention.

Referring to FIG. 1, the battery pack according to the present invention includes a plurality of cylindrical battery cells 100, a metal plate 120 configured to electrically connect the plurality of cylindrical battery cells 100 to each other, a monopole antenna 210 attached to each of the plurality of cylindrical battery cells 100, and an antenna module 220 connected to the monopole antenna 210.

FIG. 1 shows that four cylindrical battery cells 100 are included; however, the number of cylindrical battery cells is not limited thereto. However, each of the plurality of cylindrical battery cells 100 is individually coupled one-to-one to a single monopole antenna 210. In addition, all of the monopole antennas are configured to have the same size and shape in a single battery pack.

Each monopole antenna 210 radiates a unique pattern corresponding to the impedance of the cylindrical battery cell 100 to which the monopole antenna is attached. Since all of the monopole antennas have the same size and shape, the monopole antennas radiate the same pattern if the battery cells are normal.

However, in the case of a defective battery cell, the pattern radiated by the monopole antenna is distorted due to change in the impedance of the battery cell. Such a distorted pattern may be considered an abnormal pattern.

If the pattern radiated by the monopole antenna is observed as an abnormal pattern, the cylindrical battery cell to which the monopole antenna is attached may be determined to be defective.

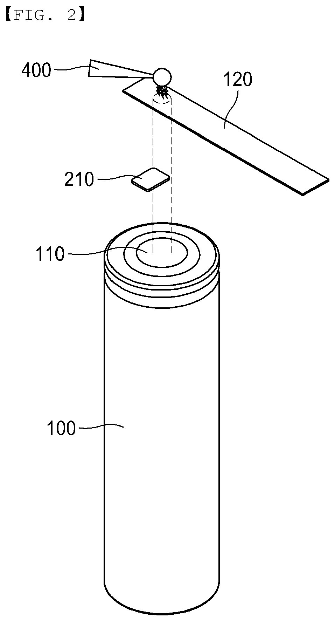

FIG. 2 is an exploded perspective view showing the relationship in which the monopole antenna and the metal plate are coupled to the cylindrical battery cell of FIG. 1.

Referring to FIG. 2 together with FIG. 1, the metal plate 120 may be coupled to the top of the cylindrical battery cell 100 for electrical connection between the cylindrical battery cells 100.

Welding using a welding apparatus 400 may be employed as a method for coupling the cylindrical battery cell 100 and the metal plate 120 to each other. For example, laser welding, resistance welding, or ultrasonic welding may be employed.

The monopole antenna 210 may be coupled to a positive electrode terminal of the cylindrical battery cell 100, and the monopole antenna 210 may be attached to the cylindrical battery cell 100 using such a welding process.

Specifically, the monopole antenna 210 may be coupled to a central protrusion of a top cap 110, which functions as the positive electrode terminal of the cylindrical battery cell 100. As shown in FIG. 2, welding may be performed in the state in which the monopole antenna 210 is interposed between the top cap 110 and the metal plate 120. Alternatively, unlike what is shown in FIG. 2, welding may be performed in the state in which the metal plate 120 is disposed on the top cap 110 and the monopole antenna 210 is disposed on the metal plate 120.

The monopole antenna 210 may be made of a metal material having excellent electrical conductivity. For example, a metal piece including copper or nickel may be used.

Considering the radiation pattern shape of the monopole antenna 210, it is preferable for the monopole antenna 210 to be rectangular rather than square in plan. Therefore, the monopole antenna 210 is configured to include a long side and a short side in the plan, wherein the short side may have a length of 1 mm or more. If the length of the short side of the monopole antenna 210 is less than 1 mm, the size of the radiation pattern is small, making it difficult to observe the radiation pattern.

The length of the long side of the monopole antenna 210 may be less than the diameter of the cylindrical battery cell. Specifically, when at least a part of the monopole antenna 210 is coupled to the top cap functioning as the positive electrode terminal, the remaining part of the monopole antenna should not be in contact with a crimping portion functioning as a negative electrode terminal.

Therefore, the length of the long side of the monopole antenna 210 may be determined considering the diameter of the cylindrical battery cell and the width of the crimping portion. For example, the length of the long side of the monopole antenna 210 may be greater than the length of the short side of the monopole antenna and less than the diameter of the central protrusion of the top cap.

Meanwhile, the thickness of the monopole antenna 210 may be selected within a range of 50 µm to 150 µm, considering weldability.

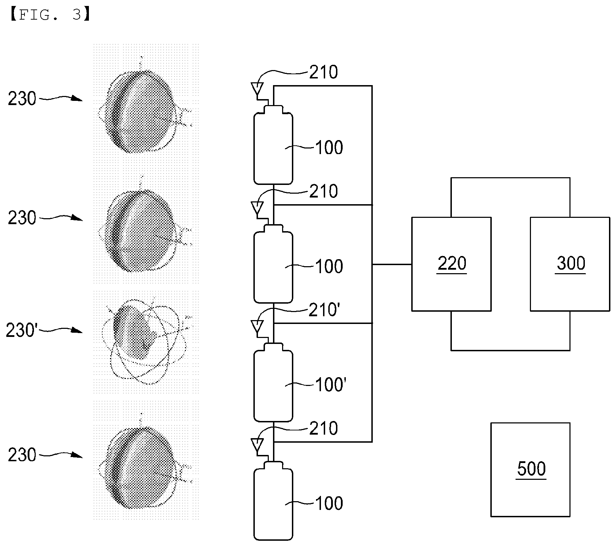

FIG. 3 is a view showing the configuration of a battery pack inspection apparatus according to the present invention.

Referring to FIG. 3, the battery pack inspection apparatus according to the present invention may determine whether the battery cells included in the battery pack are defective using a non-destructive inspection method.

Specifically, the battery pack inspection apparatus includes a power supply device 300 configured to supply power to the antenna module 220 and a measurement device 500 configured to measure the pattern of the monopole antenna attached to the battery pack.

In the battery pack inspection apparatus according to the present invention, the antenna module 220 may transmit a first signal to the monopole antennas 210, and the monopole antennas 210 that have received the first signal may radiate a second signal.

The second signal radiated by the monopole antennas 210 may vary depending on the strength of the first signal transmitted by the antenna module 220. Since prices for high-frequency components are high, the first signal may have a low frequency of 700 MHz to 1 GHz. Specifically, since the length of the short side of the monopole antenna is 1 mm or more, an antenna module having a bandwidth of 717 MHz to 861 MHz may be used.

When power is applied to the monopole antennas 210 and the cylindrical battery cells 100 in the state in which the lowermost one of the cylindrical battery cells 100 in FIG. 3 is grounded, current flows through the monopole antennas and the ground surface, radiating the second signal.

Subsequently, the ground surface is removed, and the difference in radiation patterns caused by the impedance of a normal cylindrical battery cell and the impedance of an abnormal cylindrical battery cell is analyzed.

The measurement device 500 may measure and analyze the radiation patterns 230 and 230' radiated by all of the plurality of monopole antennas 210 coupled respectively to the battery cells.

The monopole antennas 210 radiate different radiation patterns depending on the impedance of the cylindrical battery cells 100 to which the monopole antennas are coupled. The measurement device 500 measures the radiation patterns 230 and 230' of the monopole antennas 210, and, if any one of the radiation patterns 230 and 230' radiated by the plurality of monopole antennas 210 is different in shape from the others, determines that the battery cell corresponding to the different radiation pattern is defective.

For a defective cylindrical battery cell, a resonant frequency changes with increasing impedance, potentially resulting in no radiation, or a radiation pattern reduced by less than tens of times or an asymmetrical radiation pattern may appear.

In FIG. 3, the radiation pattern 230' radiated by the monopole antenna 210' coupled to cylindrical battery cell 100', among the four cylindrical battery cells 100 and 100', appears to be biased to one side. Conversely, the radiation pattern 230' radiated by the monopole antennas 210' coupled to the other cylindrical battery cells 100 is measured to be generally symmetrical, with the three monopole antennas 210' radiating the same radiation patterns. Therefore, the cylindrical battery cells 100 may be determined to be normal battery cells, and the cylindrical battery cell 100' can be determined to be a defective battery cell.

Furthermore, since the radiation patterns radiated by the monopole antennas are wireless patterns, the measurement device 500 is configured to receive wireless signals.

For example, the measurement device 500 may be an electromagnetic anechoic chamber, and the battery pack may be disposed in the electromagnetic anechoic chamber, which analyzes 3D patterns radiated by the monopole antennas to identify defective battery cells.

Alternatively, the measurement device 500 may be a spectrum analyzer, which is an instrument that decomposes the spectrum or frequency of a signal and displays the magnitude thereof on a screen. The spectrum analyzer may be connected to the battery pack to analyze the pattern of a measured signal.

As such, in the present invention, a monopole antenna configured to radiate a wireless signal is attached to each battery cell, an antenna module configured to transmit a first signal to the monopole antenna is provided, and the monopole antenna radiates a second signal corresponding to the first signal as a radiation pattern. Since the impedance of the cylindrical battery cell affects the radiation pattern, a monopole antenna coupled to a defective battery cell radiates an abnormal radiation pattern, whereby it is possible to determine that a cylindrical battery cell corresponding to the abnormal radiation pattern is defective.

Those skilled in the art to which the present invention pertains will appreciate that various applications and modifications are possible within the scope of the present invention based on the above description.

### (Description of Reference Numerals)

100, 100': Cylindrical battery cell
110: Top cap
120: Metal plate
210, 210': Monopole antenna
220: Antenna module
230, 230': Radiation pattern
300: Power supply device
400: Welding device
500: Measurement device

## Claims

1. A battery pack comprising:
a plurality of cylindrical battery cells;
a metal plate configured to electrically connect the plurality of cylindrical battery cells to each other;
a monopole antenna attached to the plurality of cylindrical battery cells; and
an antenna module connected to the monopole antenna.

2. The battery pack according to claim 1, wherein the monopole antenna is attached to each of the plurality of cylindrical battery cells.

3. The battery pack according to claim 2, wherein the monopole antenna is coupled, by welding, to a metal plate coupled to a positive electrode terminal of the cylindrical battery cell.

4. The battery pack according to claim 1, wherein the monopole antenna is made of a metal piece comprising copper or nickel.

5. The battery pack according to claim 1, wherein the monopole antenna is rectangular in plan, a length of a longer side of the rectangle being less than a diameter of the cylindrical battery cell.

6. The battery pack according to claim 5, wherein a length of a short side of the rectangular the monopole antenna is 1 mm or more.

7. A battery pack inspection apparatus for inspecting the battery pack according to any one of claims 1 to 6, the battery pack inspection apparatus comprising:
a power supply device configured to supply power to the antenna module; and
a measurement device configured to measure a pattern of the monopole antenna attached to the battery pack.

8. The battery pack inspection apparatus according to claim 7, wherein
the measurement device is an electromagnetic anechoic chamber, and
the battery pack is disposed in the electromagnetic anechoic chamber, which analyzes a 3D pattern radiated by the monopole antenna.

9. The battery pack inspection apparatus according to claim 7, wherein
the measurement device is a spectrum analyzer, and
the spectrum analyzer is connected to the battery pack to analyze a pattern of a measured signal.

10. The battery pack inspection apparatus according to claim 7, wherein
the monopole antenna radiates different radiation patterns depending on impedance of a cylindrical battery cell to which the monopole antenna is coupled, and
the measurement device measures the radiation pattern of the monopole antenna, and, if any one of the radiation patterns radiated by a plurality of monopole antennas is different in shape from the others, determines that the cylindrical battery cell corresponding to the different radiation pattern is defective.
